(19) Europäisches Patentamt
European Patent Office
Office européen des brevets

(11) Publication number: **0 147 596**
**A2**

(12) **EUROPEAN PATENT APPLICATION**

(21) Application number: **84113726.8**

(51) Int. Cl.[4]: **G 03 F 7/08**

(22) Date of filing: **14.11.84**

(30) Priority: **30.12.83 US 567029**

(43) Date of publication of application:
**10.07.85 Bulletin 85/28**

(84) Designated Contracting States:
**DE FR GB**



(71) Applicant: **International Business Machines Corporation**
**Old Orchard Road**
**Armonk, N.Y. 10504(US)**

(72) Inventor: **Economy, James**
**6694 Heathfield Drive**
**San Jose California 95120(US)**

(72) Inventor: **McKean, Dennis Richard**
**918 Boltz Ct.**
**Ft. Collins Colorado 80525(US)**

(72) Inventor: **Miller, Robert Dennis**
**6614 Tam O'Shanter Drive**
**San Jose California 95120(US)**

(72) Inventor: **Willson, Carlton Grant**
**896 Harding Avenue**
**San Jose California 95126(US)**

(74) Representative: **Hobbs, Francis John**
**IBM United Kingdom Patent Operations Hursley Park**
**Winchester, Hants, SO21 2JN(GB)**


(54) **A positive lithographic resist composition.**


(57) A positive lithographic resist compositions comprises a phenol resin and a sensitizer having the structure

$$R - O-(D-O)_n-D-OR'$$

wherein n is an integer from 1 to 5, each of R and R' is

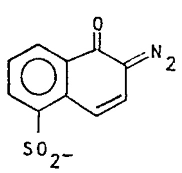

or

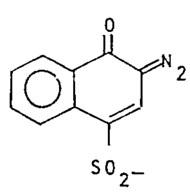

and D is $-CH_2-CH_2-$,

$$-CH_2-CH(CH_3)-$$ or $-CH_2-CH_2-CH_2-CH_2-$.


EP 0 147 596 A2


Croydon Printing Company Ltd.

A POSITIVE LITHOGRAPHIC RESIST COMPOSITION

This invention relates to a positive lithographic resist composition.

US-A-4,397,937 and EP-A1-85761 disclose positive resist compositions comprising a phenolic resin and a sensitizer which is a bis-ester of a 1-oxo-2-diazonaphthalene sulfonic acid and of an unsymmetrical primary or secondary aliphatic diol which is a mixture of geometric and diasterioisomers.

A positive lithographic resist composition comprising a phenolic resin and a sensitizer is characterised, according to the invention, by the sensitizer having the structure

$$R - O-(D-O)_n-D-OR'$$

wherein n is an integer from 1 to 5, each of R and R' is

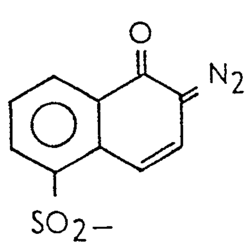

or

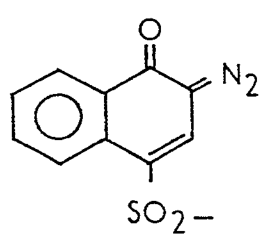

and D is $-CH_2-CH_2-$, $-CH_2-\underset{CH_3}{\underset{|}{CH}}-$ or $-CH_2-CH_2-CH_2-CH_2-$.

The resist compositions of the present invention are useful in both optical and electron beam lithography. They have unexpected advantages over the resists of US-A-4,397,937 in that with the sensitizers of the present invention, still greater solubility is achieved using common casting solvents such as diglyme, ethyl cellosolve acetate, etc.. This

advantage is most particularly significant when the diazonaphthalene portion of the molecule contains a sulfonyl group in the 4-position since sulfonate esters of this type are notoriously insoluble (see GB-1,127,996) In fact, the described bis esters with this substitution pattern are the first such derivatives which are sufficiently soluble to allow the preparation of stable sensitive resists for use in the mid UV region. In this regard, the 4-substituted materials are spectrally ideal since they have an absorption maximum around 310 nm which nicely matches the peak output of most mid UV tools. The bifunctional nature of these sensitizers coupled with the improved solubility allows the preparation of a resist with a much higher optical density in the mid UV region thus improving sensitivity. Bifunctional sensitizers allow high optical densities to be achieved at low sensitizer molal leading levels so that development may be achieved without resorting to strongly basic developers or long development times which can adversely affect the contrast and adhesion of the resist.

The host resin is a soluble phenolic resin which is transparent to the radiation to be employed. Especially useful are phenol-formaldehyde type resins and poly(p-hydroxystyrenes). Resoles may be used, but novolak resins and poly(p-hydroxystyrenes) are preferred. The most preferred resin is a cresylic acid-formaldehyde resin. It is also preferred that n in the above formula be either 2 or 3.

It should be noted that in carrying out the present invention, it is possible to use mixtures of sensitizers. The use of mixtures has the advantage of making higher concentrations of sensitizer possible and allows adjustments of the absorption spectrum of the composition such that it can be matched to the exposure tool output thereby optimizing sensitivity.

The most preferred sensitizers for use in the present invention are:

1,11-bis - (3-diazo-3,4-dihydro-4-oxo-2-naphthalene sulfonyloxy)-3,6,9-trioxaundecane (Cmpd I);

1,9-bis - (3-diazo-3,4-dihydro-4-oxo-1-naphthalene sulfonyloxy-3,4-dioxane (Cmpd II);

1,11-bis - (6-diazo-5,6-dihydro-5-oxo-1- naphthalene sulfonyloxy)-3,6,9-trioxaundecane (Cmpd III);

1,9-bis - (6-diazo-5,6-dihydro-5-oxo-1-naphthalene sulfonyloxy)-3,6-dioxanonane (Cmpd IV).

The following examples are given solely for the purpose of illustration and are not to be considered limitations on the invention, which is defined in the appended claims.

A resist formulation was made from 0.7g of Compound I and 2.78g of Varcum resin (Varcum is a trademark of Reichhold Chemical Co. for its cresol-formaldehyde resin). The mixture of these ingredients was dissolved in 6.51g of diglyme. After filtration, the resist was spin-coated on silicon wafers to a thickness of 0.7 - 1.2 μm and prebaked at 80°C for 15 minutes. The films, when exposed at 313nm (65 $mj/cm^2$) and developed with dilute potassium hydroxide solution, gave images with very little film loss in unexposed regions and produced image wall profiles equal to or better than those using the best previous aliphatic diol derivatives.

The compositions of the present invention are particularly useful and advantageous when exposed with mid UV light (300-350nm). They are, however, also useful with near ultraviolet and visible light (365-450nm), with x-rays and with e-beam irradiation.

The sensitizers for use with the present invention are best prepared as follows. The procedures are representative and are generally applicable to other polyoxa aliphatic bis ester derivatives.

Preparation of 1,11-bis (3-diazo-3,4-dihydro-4-oxo-1-naphthlene sulfonyloxy)-3, 6,9 - trioxaundecane (Compound I).

To a solution of 0.39g tetraethylene glycol, 0.3g 4-(1-pyrrolidine) pyridine, 0.81g dry triethylamine in 20mL of methylene chloride was added 2.15g of 3-diazo-3,4-dihydro-4-oxo-1-naththalene sulfonyl chloride. The resulting solution was stirred for 2 hours at 24°C. After dilution with 100mL of methylene chloride the organic layer was washed with 2N sulfuric acid, water, saturated salt solution and dried over magnesium sulfate. The solvent was removed and the residue purified by flash chromatography over silica gel to yield 0.53g (40%) of pure product.

Preparation of 1,11-bis-(6-diazo-5,6-dihydro-5-oxo-1-naphthalene sulfonyloxy)-3,6,9-trioxaundecane (Compound III)

To a solution of 0.39g of tetraethylene glycol, 0.05g 4-dimethylamino pyridine, 0.81g triethylamine in 20mL of methylene chloride at 0°C under nitrogen was added 2.15g of 6-diazo-5,6-dihydro-5-oxo-1-naphthalene sulfonyl chloride. The resulting solution was stirred for 3 hours at 0°C and diluted with 100mL of methylene chloride. The organic phase was washed with 5% HCl, water, saturated salt solution and dried over magnesium sulfate. After removal of the solvent, the residue was flash chromatographed over silica gel to give 0.83g of pure product (63%).

CLAIMS

1. A positive lithographic resist composition comprising a phenolic resin and a sensitizer, characterised by the sensitizer having the structure

$$R - O-(D-O)_n-D-OR'$$

wherein n is an integer from 1 to 5, each of R and R' is

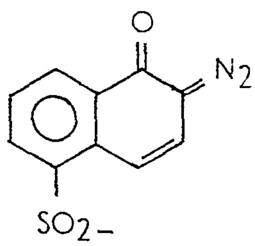

or

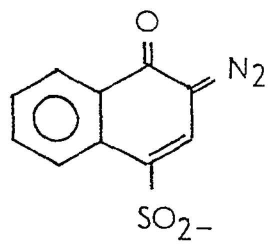

and D is $-CH_2-CH_2-$, $-CH_2-CH(CH_3)-$ or $-CH_2-CH_2-CH_2-CH_2-$.

2. A composition as claimed in claim 1, wherein R and R' are different.

3. A composition as claimed in claim 1 or claim 2, wherein n is 2.

4. A composition as claimed in claim 1 or claim 2, wherein n is 3.

5. A composition as claimed in any preceding claim, wherein the sensitizer comprises a mixture of compounds.